# EUROPÄISCHE PATENTSCHRIFT

(11) **EP 0 411 256 B1**
(45) Veröffentlichungstag und Bekanntmachung des Hinweises auf die Patenterteilung: **02.03.1994**
(21) Anmeldenummer: 90109079.5
(22) Anmeldetag: 14.05.1990
(51) Int. Cl.: C23C 14/34, H01J 37/34, C23C 14/56, C23C 14/04, B25J 19/00

(54) **Kathodenzerstäubungsanlage**
Cathodic sputtering apparatus
Dispositif de pulvérisation cathodique

(30) Priorität: 03.08.1989 DE 3925711
(43) Veröffentlichungstag der Anmeldung: 06.02.1991
(73) Patentinhaber: KERNFORSCHUNGSZENTRUM KARLSRUHE GMBH, D-76021 Karlsruhe (DE)
(72) Erfinder: Hilz, Gabriela, D-7500 Karlsruhe 31 (DE); Walter, Stefan, D-6521 Dorn-Dürkheim (DE)

(56) Entgegenhaltungen:
- IBM TECHNICAL DISCLOSURE BULLETIN Bd. 18, Nr. 4, 1. September 1975, Seiten 1284-1285; M. ENTNER et al.: 'Removable, masking covers for sputtering systems.'

## Beschreibung

Die Erfindung betrifft eine Kathodenzerstäubungsanlage nach dem Oberbegriff des ersten Patentanspruchs.

Solche Kathodenzerstäubungsanlagen werden verwendet, um Proben mit dünnen Beschichtungen, z. B. von Hartstoffen, zu versehen.

Die Kathodenzerstäubungsanlagen weisen einen Rezipienten auf, in den die zu beschichtenden Proben eingebracht werden. In das Rezipientenoberteil sind eine oder mehrere Kathoden eingesetzt, auf denen auf der Rezipienteninnenseite das zu zerstäubende Material (Target) aufgebracht ist.

Die Proben können innerhalb des Rezipienten relativ zu den Targets bewegt werden, beispielsweise mit Hilfe eines Drehtellers, auf dem die Proben abgesetzt werden.

Zur Beschichtung der Proben wird der Rezipient evakuiert und danach ein Inertgas (meist Argon) bis zu einem Druck in der Größenordnung von 10⁻² mbar eingelassen. An den Kathoden wird ein negatives Potential in der Größenordnung von einigen Hundert bis Tausend Volt angelegt, wobei je nach Betriebszustand der Drehteller oder die Wand des Rezipienten als Masse geschaltet ist. Im Rezipienten entsteht eine Glimmentladung, wobei sich Inertgas-Ionen bilden, die im elektrischen Feld beschleunigt werden und mit hoher Geschwindigkeit auf dem Target auftreffen. Aus der Oberfläche des Targets werden Atome und Molekülfragmente herausgeschlagen, die sich auf der Probe, aber auch im gesamten Rezipienten als dünne Schicht niederschlagen. Bevor die Beschichtung der Proben vorgenommen werden kann, müssen die Targets gereinigt werden. Hierzu wird auf eine Target-Abdeckung, im allgemeinen auf eine verschieb- oder drehbare Blende, abgestäubt. Anschließend werden die Proben gereinigt. Dazu wird zwischen Drehteller und Rezipientenwand eine Glimmladung erzeugt, indem an dem Drehteller ein negatives Potential angelegt wird, wobei die Rezipientenwand an Masse liegt.

Mit einer solchen Kathodenzerstäubungsanlage können jedoch nicht mehrere Proben mit unterschiedlichen Materialien in einem einzigen Verfahrenszyklus beschichtet werden, da eine Verunreinigung mit den jeweils anderen Schichtmaterialien unvermeidlich ist.

In diesem Fall müssen die Proben nacheinander beschichtet werden, wobei jedesmal der Rezipient zum Probenaustausch belüftet und anschließend wieder evakuiert werden muß. Die Pumpzeit beträgt dabei im allgemeinen 4 bis 5 Stunden.

Wenn aus einer Reihe von Proben jeweils nur wenige Proben mit der gleichen Beschichtung versehen werden sollen, kann ferner der im Rezipienten für die Proben zur Verfügung stehende Platz nicht optimal genutzt werden.

Zwar ist es bekannt, Kathodenzerstäubungsanlagen für die Serienbeschichtung von Proben mit Probenschleusen zu versehen.

Insbesondere für den Einsatz in Labor- oder Kleinserienanlagen sind solche Probenschleusen aber nur bedingt verwendbar, weil die Positionierung der Proben unter dem Target kaum variabel ist und weil der Anwender hinsichtlich der Probengeometrie eingeschränkt ist.

Zudem sind solche Probenschleusen u. a. wegen der erforderlichen Zusatzaggregate teuer und mitunter in ihrer Funktion unzuverlässig.

Aus der DD-PS 111 409 ist eine Zerstäubungsanlage bekannt, bei der die Targets auf einer absenkbaren Drehvorrichtung angebracht sind und die Proben in entsprechende Bearbeitungsstationen eingebracht werden, wodurch sich mehrere Substrate mit unterschiedlichen Materialien in einem einzigen Verfahrenszyklus ohne Verwendung einer Probenschleuse beschichten lassen. Bei dieser Zerstäubungsanlage entspricht die Zahl der Probenplätze jedoch der Zahl der verwendeten Targets, so daß sich der vorhandene Platz bei kleinen Proben nicht vollständig nutzen läßt. Die Größe der Probenplätze ist ferner durch die Größe der Targets festgelegt, weshalb größere Proben nicht beschichtet werden können.

Aus IBM TECHNICAL DISCLOSURE BULLETIN Bd. 18, Nr. 4, 1. September 1975, Seiten 1284-1285; M. Entner et al. "Removable masking covers for sputtering systems" ist eine Abdeckungssystem für ein Sputteranlage bekannt, wobei im Rezipienten Abdeckungen aus Teilweise magnetisierbarem Material vorhanden sind, mit denen sich Substrate abdecken lassen, wobei die Abdeckungen mittels auf einem drehbaren Trägerarm angeordneten Elektromagneten angehoben und bewegt werden können.

Aufgabe der Erfindung ist, die angesprochenen Nachteile bekannter Kathodenzerstäubungsanlagen zu vermeiden und insbesondere eine Kathodenzerstäubungsanlage vorzuschlagen, mit der mehrere Proben mit unterschiedlichen oder verschieden dicken Beschichtungen versehen werden können, ohne daß der Rezipienten zwischenzeitlich belüftet und wieder evakuiert werden muß. Weiterhin soll sich der im Rezipienten für die Proben vorhandene Platz bei jeder Evakuierung auch dann vollständig nutzen lassen, wenn Proben mit unterschiedlichen oder verschieden dicken Beschichtungen versehen werden sollen.

Zur Lösung der Aufgabe wird erfindungsgemäß eine Kathodenzerstäubungsanlage mit den kennzeichnenden Merkmalen des ersten Patentanspruchs vorgeschlagen.

Die Unteransprüche geben vorteilhafte Ausgestaltungen der Erfindung an.

Erfindungsgemäß werden die Proben vor dem Evakuieren des Rezipienten bis zu ihrer Beschichtung mit Abdeckungen, die teilweise oder ganz aus magnetisierbaren Material bestehen, gegen eine unerwünschte Beschichtung abgeschirmt. Wenn alle Proben abgedeckt werden erübrigt sich eine besondere Abdeckung der Targets für deren Reinigung vor dem Beschichten der Proben, z. B. die bekannte drehbare Blende. Im Rezipientenoberteil ist eine Vakuumdurchführung angebracht, durch die zwei bezüglich des Rezipientenoberteils senkrecht angeordnete Stäbe aus weichmagnetischem Material in den Rezipienten hineinragen. Im evakuierten Rezipienten können die Probenabdeckungen nach Belieben angehoben, beiseite gestellt und wieder zurückgestellt werden, indem die außerhalb des Rezipienten liegenden Enden der Stäbe mit einer Magnetisierungsvorrichtung, z. B. einer elektrischen Spule oder einem Permanentmagneten, überbrückt werden und mit dem Drehteller eine gewünschte Position angefahren wird.

Besonders bevorzugt ist eine elektrische Spule als Magnetisierungsvorrichtung, denn ein eventuell verbleibender, störender Restmagnetismus des magnetischen Materials läßt sich durch Umpolen leicht reduzieren oder ganz beseitigen.

Ein weiterer Vorteil ist, daß sich im Gegensatz zum Permanentmagneten die magnetische Feldstärke variieren läßt.

Eine hohe magnetische Feldstärke ist nur zum Anheben der Abdeckungen erforderlich; nach Überwindung des Spalts, d. h. bei angezogener Abdeckung, genügt eine wesentlich geringere magnetische Feldstärke, um die Abdeckung festzuhalten. Damit wird das Überfahren anderer Abdeckungen möglich, die sonst bei gleichbleibend hoher Anziehungskraft ebenfalls angehoben oder zumindest verschoben werden könnten.

Als weichmagnetisches Material für die Stäbe und als magnetisierbares Material für die Abdeckungen der Proben können prinzipiell die bekannten Materialien verwendet werden. In beiden Fällen wird wegen des geringen Restmagnetismus Weicheisen bevorzugt.

Um die Kathodenzerstäubung möglichst wenig zu beeinträchtigen, soll die Magnetisierungsvorrichtung während des Abstäubens entfernt werden.

Aus dem gleichen Grund wird die Fläche des magnetisierbaren Materials auf den Probenabdeckungen möglichst klein gehalten. Vorzugsweise wird ein Weicheisenband auf den Abdeckungen angebracht, das in seinen Dimensionen auf den Abstand der Stäbe abgestimmt ist.

Die Abdeckungen können an verschiedene Probengeometrien angepaßt werden. Sollen verschiedene Sätze unterschiedlich hoher Abdeckungen verwendet werden, empfiehlt es sich, die Stäbe an ihren im Rezipienten liegenden Enden mit einer axial verschiebbaren Hülse oder einem axial verschiebbaren Stift aus weichmagnetischem Material zu versehen, so daß deren Länge vor dem Evakuieren an die Höhe der Abdeckungen angepaßt werden kann. Z. B. können Weicheisenstäbe mit einem Außengewinde versehen werden, auf das eine Weicheisenhülse teilweise oder ganz aufgeschraubt wird. Es können jedoch auch Hülsen mit Klemmschrauben oder in die Weicheisenstäbe einschiebbare Stifte etc. verwendet werden.

Der wesentliche Vorteil der Erfindung besteht darin, daß die bekannten Kathodenzerstäubungsanlagen auf einfache Weise nachgerüstet werden können. Die erfindungsgemäße Anlage ist einfach und zuverlässig zu bedienen, wobei der Beschichtungsvorgang selbst nicht beeinflußt wird. Sie erlaubt eine größtmögliche Flexibilität in der Probengeometrie, da lediglich ausreichend dimensionierte Probenabdeckungen zur Verfügung stehen müssen, die sich einfach und preisgünstig herstellen lassen. Der im Rezipienten vorhandene Platz kann optimal genutzt werden, weil durch die Abdeckungen eine unerwünschte Beschichtung zuverlässig verhindert werden kann.

Eine vorgegebene Reihenfolge der Beschichtung braucht nicht eingehalten zu werden, da durch die Magnetisierungsvorrichtung und den Drehteller jede beliebige Abdeckung auf einen anderen Platz transportiert werden kann. Die Zahl der mit verschiedenen Materialien beschichtbaren Proben hängt lediglich von der Zahl der Targets und vom zur Verfügung stehenden Platz im Rezipienten ab. Ferner können Proben mit definierten, unterschiedlich dicken Beschichtungen versehen werden.

Die Erfindung wird im folgenden anhand eines Durchführungsbeispiels und der Figuren näher erläutert.

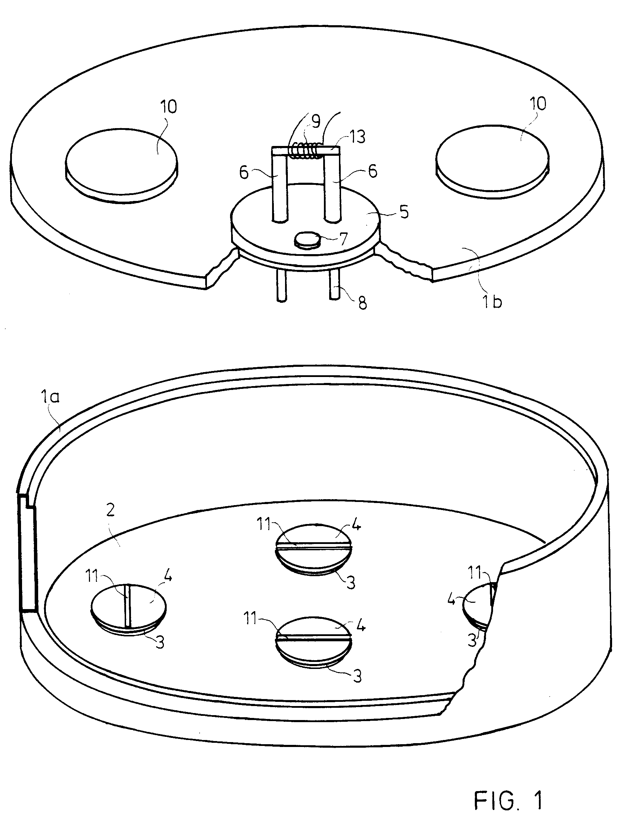

Figur 1 zeigt die erfindungsgemaße Kathodenzerstäubungsanlage.

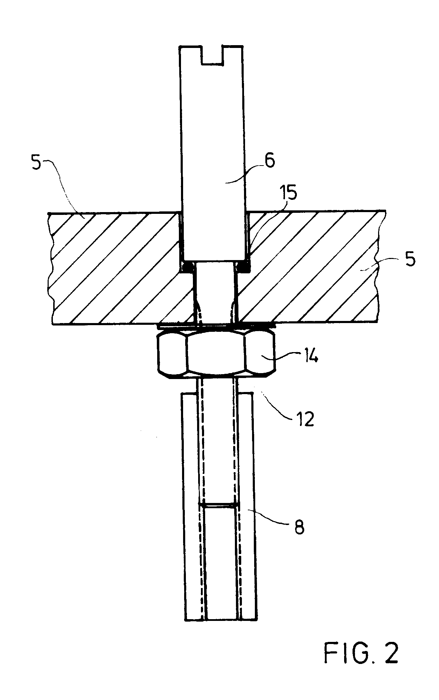

Figur 2 zeigt die Vakuumdurchführung mit einem der beiden Weicheisenstäbe.

Der Rezipient besteht aus dem Unterboden 1a und dem Rezipientenoberteil 1b. Im Unterboden 1a ist der Drehteller 2 angebracht, mit dem sich die Proben unter den Targets 10 positionieren lassen. Vor dem Evakuieren werden auf dem Drehteller Distanzringe 3 abgelegt, die die Proben (in der Figur nicht dargestellt) umschließen. Jeder Distanzring wird mit einer Probenabdeckung 4 abgeschirmt, auf deren Oberseite ein Weicheisenstreifen 11 aufgeschraubt ist. Distanzring 3 und Probenabdeckung 4 können jedoch auch miteinander verbunden sein, wenn eine größer dimensionierte Spule verwendet wird, durch die die Nachteile der größeren zu überwindenden Höhe und des zusätzlichen Gewichts kompensiert werden.

Das Rezipientenoberteil 1b nimmt die Targets 10 und die Vakuumdurchführung 5 auf. Durch die Vakuumdurchführung sind die magnetisierbaren Weicheisenstäbe 6 geführt. Außerhalb des Rezipienten 1a, 1b werden die Weicheisenstäbe 6 durch eine entfernbare elektrische Spule 9, die auf einem Joch 13 angebracht ist, überbrückt. An ihren innerhalb des Rezipienten liegenden Enden weisen die Weicheisenstäbe 6 ein Außengewinde 12 auf, auf die Weicheisen-Gewindehülsen 8 so aufgeschraubt sind, daß sie bei aufgesetztem Rezipientenoberteil ca. 1 cm von der Probenabdeckung 4 entfernt sind.

In die Vakuumdurchführung ist ferner eine Glasscheibe 7 eingelassen, mit deren Hilfe das Rezipienteninnere beleuchtet und durch ein seitliches (nicht dargestelltes) Sichtfenster eingesehen werden kann.

Vor der Probenbeschichtung werden die Distanzringe 3 auf einer Kreislinie, die den möglichen Positionen unterhalb der Targets entspricht, auf dem Drehteller 2 abgelegt, wobei ein Platz zur Ablage einer Probenabdeckung freibleibt.

Innerhalb der Distanzringe 3 werden eine oder mehrere gleichartig zu beschichtende Proben positioniert. Schließlich werden sämtliche Distanzringe 3 mit den Probenabdeckungen 4 abgedeckt.

Der Rezipientenunterboden 1a wird mit dem Rezipientenoberteil 1b verschlossen, wobei die elektrische Spule 9 mit dem Joch 13 abgenommen wird.

Danach wird der Rezipient so weit wie möglich evakuiert und Argon eingelassen. An die Targets werden negative Potentiale angelegt, wobei der Drehteller an Masse liegt. Hierbei werden die Targets gereinigt.

Danach werden mit dem Joch 13 und der elektrischen Spule 9 die Weicheisenstäbe 6 überbrückt. Mit Hilfe des Drehtellers wird die erste zu beschichtende Probe unter die Vakuumdurchführung positioniert. Durch Anlegen einer ausreichenden elektrischen Spannung an die Spule wird die Probenabdeckung 4 angehoben und mit Hilfe des Drehtellers 2 auf dem freigehaltenen Platz abgelegt. Die Spannung wird nach dem Abheben verringert. Zum Ablegen der Abdeckung wird schließlich kurzzeitig umgepolt, um einen eventuellen Restmagnetismus zu verringern.

Danach kann die freigelegte Probe mit dem gewunschten Target beschichtet werden. Vor dem Beschichten der nächsten Probe wird die entsprechende Abdeckung über der bereits beschichteten Probe abgelegt. Auf diese Weise wird verfahren, bis sämtliche Proben beschichtet sind.

### Bezugszeichenliste

- 1a: Rezipientenunterboden
- 1b: Rezipientenoberteil
- 2: Drehteller
- 3: Distanzring
- 4: Abdeckung
- 5: Vakuumdurchführung
- 6: Weicheisenstäbe
- 7: Sichtfenster
- 8: Gewindehülsen
- 9: Spule
- 10: Targets
- 11: Weicheisenstreifen
- 12: Außengewinde
- 13: Joch
- 14: Feststellmutter
- 15: O-Ring

## Patentansprüche

1. Kathodenzerstäubungsanlage
a) mit einem Rezipienten zur Aufnahme von zu beschichtenden Proben,
b) mit einem Rezipientenoberteil (1b), das mindestens eine Kathode enthält, auf der das zu zerstäubende und als Target (10) dienende Material aufgebracht ist,
c) mit einem Drehteller (2) zum Positionieren der Proben relativ zum Target (10), wobei die Proben auf dem Drehteller (2) angeordnet sind dadurch gekennzeichnet, daß
d) das Rezipientenoberteil (1b) eine Vakuumdurchführung (5) enthält, durch die zwei bezüglich des Rezipientenoberteils (1b) vertikal angeordnete Stäbe (6) aus weichmagnetischem Material in den Rezipienten hineinragen,
e) die außerhalb des Rezipienten liegenden Enden der Stäbe (6) durch eine Magnetisierungsvorrichtung (9, 13) überbrückbar sind,
f) im Rezipienten mindestens eine teilweise oder ganz aus magnetisierbarem Material bestehende und im Rezipienten frei bewegbare Abdeckung (4) vorhanden ist, mit der sich die Proben abdecken lassen, wobei die Probenabdeckungen (4) mittels der Stäbe (6) angehoben werden können, indem die außerhalb des Rezipienten liegenden Enden der Stäbe (6) durch eine Magnetisierungsvorrichtung überbrückt werden.

2. Kathodenzerstäubungsanlage nach Anspruch 1, dadurch gekennzeichnet, daß das magnetisierbare Material Weicheisen ist.

3. Kathodenzerstäubungsanlage nach Anspruch 2, dadurch gekennzeichnet, daß auf der Oberseite der Abdeckung (4) für die Proben ein Weicheisenband (11) aufgebracht ist.

4. Kathodenzerstäubungsanlage nach Anspruch 1, dadurch gekennzeichnet, daß die Magnetisierungsvorrichtung (9, 13) aus einer elektrischen Spule (9) oder einem Permanentmagneten besteht.

5. Kathodenzerstäubungsanlage nach Anspruch 1, dadurch gekennzeichnet, daß die Stäbe (6) aus Weicheisen bestehen.

6. Kathodenzerstäubungsanlage nach Anspruch 1 oder 5, dadurch gekennzeichnet, daß die Stäbe (6) auf ihren in das Rezipienten hineinragenden Enden mit einem axial verschiebbaren Stift oder einer axial verschiebbaren Hülse (8) versehen sind.

## Claims

1. Cathode sputtering system, having
a) a container for receiving samples to be coated,
b) an upper portion (1b) of the container, which contains at least one cathode, to which the material to be sputtered and serving as target (10) is applied,
c) a turntable (2) for positioning the samples relative to the target (10), the samples being disposed on the turntable (2), characterised in that
d) the upper portion (1b) of the container is provided with a vacuum passage (5), through which two rods (6), which are disposed vertically relative to the upper portion (1b) of the container and are formed from mildly magnetic material, protrude into the container,
e) the ends of the rods (6) situated externally of the container can be bridged by a magnetising device (9, 13),
f) at least one covering (4), which is partially or wholly formed from magnetisable material and is freely displaceable in the container, is present in the container, and the samples can be covered by said covering, the sample coverings (4) being raisable by means of the rods (6), in that the ends of the rods (6), situated externally of the container, are bridged by a magnetising device.

2. Cathode sputtering system according to claim 1, characterised in that the magnetisable material is soft iron.

3. Cathode sputtering system according to claim 2, characterised in that a soft-iron strip (11) is applied to the upper surface of the covering (4) for the samples.

4. Cathode sputtering system according to claim 1, characterised in that the magnetising device (9, 13) comprises an electric coil (9) or a permanent magnet.

5. Cathode sputtering system according to claim 1, characterised in that the rods (6) are formed from soft iron.

6. Cathode sputtering system according to claim 1 or 5, characterised in that, on their ends protruding into the container, the rods (6) are provided with an axially displaceable pin or an axially displaceable sleeve (8).

## Revendications

1. Dispositif de pulvérisation cathodique comprenant :
a) un récipient pour recevoir les éprouvettes à revêtir,
b) une partie supérieure de récipient (1b), qui contient au moins une cathode, sur laquelle est introduit le matériau à pulvériser et servant de cible (10),
c) un dispositif pour positionner les éprouvettes par rapport à la cible (10), les éprouvettes étant placées sur le plateau tournant,
caractérisé en ce que :
d) la partie supérieure du récipient (1b) comporte un passage pour le vide (5), à travers lequel dépassent dans l'intérieur du récipient les deux tiges (6) en matériau magnétique doux placées verticalement par rapport à la partie supérieure (1b) du récipient,
e) les extrémités des tiges (6) situées à l'extérieur du récipient peuvent être pontées par un dispositif (9, 13) d'aimantation,
f) dans le récipient il existe au moins un recouvrement (4) composé partiellement ou totalement de matériau magnétisable et déplaçable librement dans le récipient, avec lequel les éprouvettes peuvent être recouvertes, et les recouvrements d'éprouvettes (4) peuvent être enlevés au moyen des tiges (6), en pontant les extrémités des tiges (6) situées extérieurement au récipient par un dispositif d'aimantation.

2. Dispositif de pulvérisation cathodique selon la revendication 1, caractérisé en ce que : le matériau magnétisable est du fer doux.

3. Dispositif de pulvérisation cathodique selon la revendication 2, caractérisé :
- en ce que sur la face supérieure du recouvrement (4) est installée une bande de fer doux (11) pour les éprouvettes.

4. Dispositif de pulvérisation cathodique sen la revendication 1, caractérisé :
- en ce que le dispositif d'aimantation (9, 13) est composé d'une bobine électrique (9) ou d'un aimant permanent.

5. Dispositif de pulvérisation cathodique selon la revendication 1, caractérisé :
- en ce que les tiges (6) sont en fer doux.

6. Dispositif de pulvérisation cathodique selon les revendications 1 ou 5, caractérisé :
- en ce que les tiges (6) à leurs extrémités dépassant dans le récipient sont munies d'une broche déplaçable axialement ou d'un manchon (8) déplaçable axialement.
